# EUROPEAN PATENT SPECIFICATION

(11) **EP 2 496 053 B1**
(45) Date of publication and mention of the grant of the patent: **10.04.2019**
(21) Application number: 10826531.5
(22) Date of filing: 15.10.2010
(51) Int. Cl.: H01L 27/32

(54) **ORGANIC EL MODULE**
ORGANISCHES EL-MODUL
MODULE ÉLECTROLUMINESCENT ORGANIQUE

(30) Priority: 30.10.2009 JP 2009249701
(43) Date of publication of application: 05.09.2012
(73) Proprietor: Nippon Seiki Co., Ltd., Niigata 940-8580 (JP)
(72) Inventor: YAMANAKA,Yoshiomi, Niigata (JP)
(74) Representative: Jackson, Richard Eric
(86) International application number: PCT/JP2010/068107
(87) International publication number: WO 2011/052397

(56) References cited:
- JP-A- 2003 295 785
- JP-A- 2004 119 967
- JP-A- 2004 133 428
- JP-A- 2004 163 827
- JP-A- 2004 279 574
- JP-A- 2006 031 034
- JP-A- 2008 209 792
- JP-A- 2009 251 182
- US-A1- 2007 035 486

## Description

### TECHNICAL FIELD

The invention relates to an organic EL module which is provided with a light-emitting display having plural first electrode lines formed on a support substrate, an organic light-emitting layer formed on the first electrode lines, and plural second electrode lines formed so as to intersect with the first electrode lines.

### BACKGROUND ART

As the conventional organic EL panels, there has been known a type of having a light-emitting display which has organic EL elements formed on a transparent support substrate as light-emitting pixels, the organic EL elements being formed by interposing an organic layer at least having an organic light-emitting layer between anode lines (first electrode lines) formed of ITO (Indium Tin Oxide) and the like and cathode lines (second electrode lines) formed of aluminum (Al) and the like (for example, refer to Patent Document 1). The organic EL element injects a hole from the anode and injects an electron from the cathode; and the hole and the electron are re-coupled in the organic light-emitting layer, hence to emit a light. The organic EL element has a so-called diode characteristic that a current hardly flows from the cathode to the anode.

As a method of installing a driver IC for driving the organic EL element, there has been known a COG (Chip on Glass) mode of directly mounting the driver IC on the support substrate (for example, refer to Patent Document 2). A COG typed organic EL module is superior in downsizing. Patent Document 3 describes a signal transmission circuit which includes an electro-optical substrate having electro-optical elements. JP 2008/209792 describes an LCD panel with connection wirings formed on circuit board substrates.

### RELATED ART DOCUMENTS

### Patent Documents

Patent Document 1: JP-A-8-315981
Patent Document 2: JP-A-2000-40585
Patent Document 3: US 2007/035486 A1

### DISCLOSURE OF THE INVENTION

### PROBLEMS TO BE SOLVED BY THE INVENTION

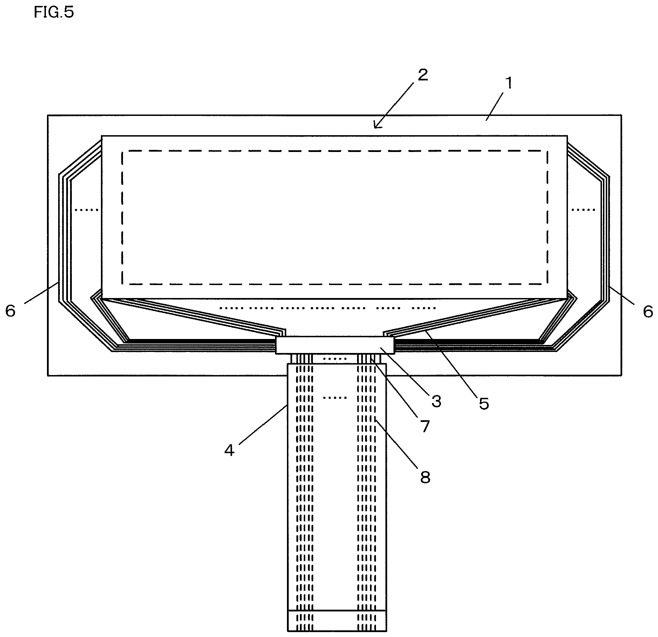

Fig. 5 shows a COG typed organic EL module. A light-emitting display 2 and a driver IC 3 are provided on a support substrate 1. Further, an FPC (Flexible Printed Circuit) 4 is installed on the support substrate 1 as an electrically connecting means to the driver IC 3. Although a sealing material for hermetically covering the light-emitting display 2 is provided on the support substrate 1, the sealing material is omitted in Fig. 5. In the COG typed organic EL module, hitherto fore, plural anode wirings 5 for connecting respective anode lines of the light-emitting display 2 to the driver IC 3, plural cathode wirings 6 for connecting respective cathode lines of the light-emitting display 2 to the driver IC 3, and an input wiring 7 for connecting the driver IC 3 to an external circuit are drawn and formed on the support substrate 1. The input wiring 7 is connected to a connecting wiring 8 formed on the FPC 4. In Fig. 5, a part of the anode wirings 5, the cathode wirings 6, and the input wiring 7 is omitted.

The anode wirings 5 and the cathode wirings 6 formed on the support substrate 1, however, are some hundreds nm thin in conductor thickness and large in resistance. Accordingly, the thinner the wiring width gets, the larger the resistance becomes, and as a result, a voltage drop becomes large. In this case, brightness of an organic EL element is reduced disadvantageously because of a restriction in a driving voltage of the driver IC 3. The number of the anode wirings 5 and the cathode wirings 6 is increased as the number of dots of light-emitting pixels on the light-emitting display 2 gets larger and the width of the wiring per one wiring gets thinner. Particularly, when the cathode wirings 6 are drawn on the lateral sides of the support substrate 1, as illustrated in Fig. 5, the wiring length of the cathode wirings 6 gets longer than the length of the anode wirings 5, which causes a remarkable increase in wiring resistance. Depending on the design, there is a case in which the anode wirings 5 or the input wiring 7 may be drawn on the lateral sides of the support substrate 1.

Taking the above mentioned problem into consideration, the invention aims to provide an organic EL module capable of improving brightness of an organic EL element, by reducing wiring resistance and restraining a voltage drop in a COG typed organic EL module.

### MEANS FOR SOLVING THE PROBLEMS

In order to solve the problem, the invention is an organic EL module having a light-emitting display including plural first electrode lines formed on a support substrate, an organic light-emitting layer formed on the first electrode lines, and plural second electrode lines formed so as to intersect with the first electrode lines, a driver IC which is provided on the support substrate for applying a drive current between the first and second electrode lines, and a circuit board which is installed on the support substrate for connecting the driver IC to an external circuit, in which a first wiring with its one end connected to the driver IC and a second wiring decoupled from the first wiring are formed on the support substrate, and the first wiring is connected to the second wiring through a third wiring formed on the circuit board.

The second wiring is formed with one end connected to the first electrode lines or the second electrode lines and the other end connected to the third wiring.

On the circuit board, plural connecting units for connecting the third wiring to the first and second wirings are formed in rows on one side and intervals between the connecting units are wider on the lateral sides than intervals between the connecting units in a middle portion.

The circuit board is a flexible substrate.

### ADVANTAGE OF THE INVENTION

As mentioned above, according to the invention, in a COG typed organic EL module, by reducing wiring resistance, it is possible to restrain a voltage drop and to improve brightness of an organic EL element.

### BRIEF DESCRIPTION OF THE DRAWINGS

Fig. 1 is a view showing an organic EL module of an embodiment of the invention.
Fig. 2 is an enlarged view of an important portion of the organic EL module.
Fig. 3 is a cross-sectional view showing an organic EL element indicating the organic EL module.
Fig. 4 is an enlarged view of an important portion of the organic EL module.
Fig. 5 is a view showing the conventional organic EL module.

### MODE FOR CARRYING OUT THE INVENTION

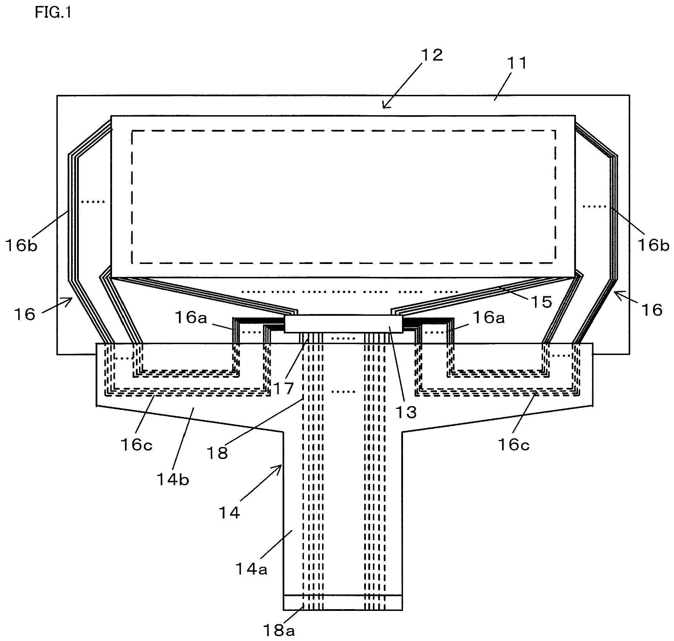

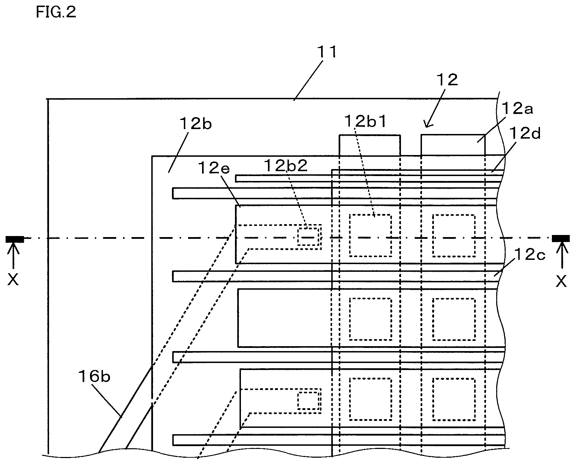

Hereinafter, an organic EL module that is an embodiment of the invention will be described according to the attached drawings. Fig. 1 is a view showing the whole organic EL module and Figs. 2 to 4 are enlarged views of an important portion of the organic EL module. In the drawings, a part of respective wirings described later is omitted.

A support substrate 11 is an electrically insulating substrate made of a rectangular transparent glass material. A light-emitting display 12 and a driver IC 13 are provided on the support substrate 11. An FPC 14 is installed on the support substrate 11 as a means for electrically connecting to the driver IC 13. Further, anode wirings 15 connected to respective anode lines of the light-emitting display 12 described later, a first wiring 16a and a second wiring 16b that are some parts of cathode wirings 16 connected to respective cathode lines of the light-emitting display 12 described later, and an input wiring 17 for electrically connecting the driver IC 13 to an external circuit are formed on the support substrate 11. Although a sealing material for hermetically covering the light-emitting display 12 is provided on the support substrate 11, the sealing material is omitted in Figs. 1, 3, and 4.

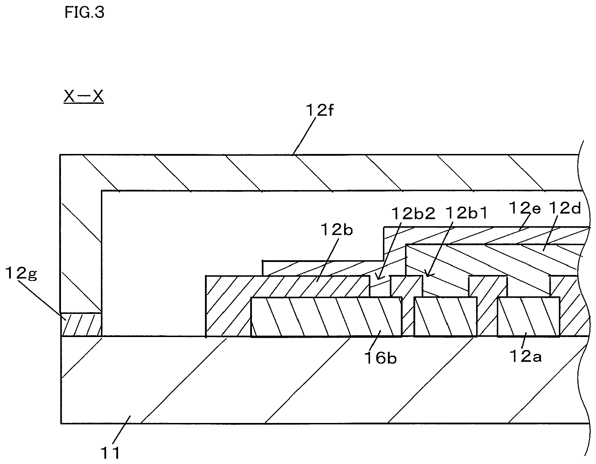

The light-emitting display 12 mainly includes plural anode lines (first electrode lines) 12a, an insulating film 12b, a partition wall 12c, an organic layer 12d, and plural cathode lines (second electrode lines) 12e, as illustrated in Figs. 2 and 3, and it is what is called a passive matrix light-emitting display including plural light-emitting pixels (organic EL element) which are formed by intersecting the respective anode lines 12a and the respective cathode lines 12e and interposing the organic layer 12d therebetween. Further, the light-emitting display 12 is hermetically covered by a sealing material 12f, as illustrated in Fig. 3.

The anode lines 12a are made of a transparent conductive material such as ITO. After the conductive material is formed into a layer shape on the support substrate 11 through vapor deposition, sputtering, and the like, the anode lines 12a are formed in almost parallel through a photolithography method and the like. One ends (the lower side in Fig. 1) of the respective anode lines 12a are connected to the respective anode wirings 15.

The insulating film 12b is made of an electrically insulating polyimide material, for example, and positioned between the anode lines 12a and the cathode lines 12e, hence to prevent short of the both electrode lines 12a and 12e. The insulating film 12b is provided with openings 12b1 which define and clearly outline the respective light-emitting pixels. Further, the insulating film 12b is extended between the cathode wirings 16 and the cathode lines 12e and provided with contact holes 12b2 which connect the respective cathode wirings 16 to the respective cathode lines 12e.

The partition wall 12c is made of an electrically insulating phenolic material, for example, and formed on the insulating film 12b. The partition wall 12c is formed so that its cross section has an inverted taper shape with respect to the insulating film 12b, according to the photolithography and the like. The plural partition walls 12c are formed in a direction orthogonal to the anode lines 12a at regular intervals. The partition wall 12c is designed to decouple the organic layer 12d and the cathode lines 12e when forming the organic layer 12d and the cathode lines 12e through the vapor deposition, sputtering and the like from above.

The organic layer 12d is formed on the anode lines 12a and at least provided with an organic light-emitting layer. In this embodiment, the organic layer 12d is formed by sequentially stacking a hole injection layer, a hole transport layer, the organic light-emitting layer, and an electron transport layer through the vapor deposition, sputtering, and the like.

The plural cathode lines 12e are formed of a metal conductive material such as aluminum (Al), and magnesium silver (Mg : Ag) having a higher conductivity than that of the anode lines 12a, through the vapor deposition or the like, in a way of intersecting with the respective anode lines 12a. The respective cathode lines 12e are connected to the respective second wirings 16b through the contact holes 12b2 provided on the insulating film 12b.

The sealing material 12f is formed of, for example, a glass material and provided on the support substrate 1 through a bonding agent 12g, in order to hermetically accommodate the light-emitting display 12.

The driver IC 13 forms a driving circuit which makes the light-emitting display 12 emit a light and includes a signal line driving circuit, a scanning line driving circuit, and the like. The driver IC 13 is provided on the support substrate 11 in accordance with the light-emitting display 12 through a COG technique and electrically connected to the respective anode lines 12a and the respective cathode lines 12e through the respective anode wirings 15 and the respective cathode wirings 16, to apply a drive current between the respective anode lines 12a and the respective cathode lines 12e.

The FPC 14 is a flexible circuit board, which is formed into a substantially T-letter shape, provided with a connecting wiring 18 to be connected to the input wiring 17 on a central portion 14a, and provided with third wirings 16c that are some parts of the cathode wirings 16 to be connected to the cathode lines 12e on the light-emitting display 12, in both lateral portions 14b. In Fig. 1, the connecting wirings 18 and the third wirings 16c formed on the back side of the FPC 14 are shown by a dotted line.

The anode wiring 15 is a wiring for connecting the anode line 12a to the driver IC 13 and formed of a conductive material of, for example, ITO that is the same material as that of the anode line 12a, chrome (Cr), aluminum (Al), or the like, or a stack of these conductive materials. The anode wirings 15 are formed on the support substrate 11 integrally with the anode lines 12a, or formed separately so as to be connected to the anode lines 12a.

The cathode wiring 16 is a wiring for connecting the cathode line 12e to the driver IC and formed by first and second wirings 16a and 16b that are metal wirings formed on the support substrate 11 and the third wiring 16c that is a copper foil wiring formed on the FPC 14. The first and second wirings 16a and 16b are decoupled on the support substrate 11 and connected to each other through the third wiring 16c on the FPC 14.

The first and second wirings 16a and 16b are formed of a conductive material of, for example, ITO that is the same material as that of the anode line 12a, chrome (Cr), aluminum (Al), or the like, or a stack of these conductive materials. The first wirings 16a are wirings formed near the driver IC 13 on the support substrate 11, with their one ends connected to the driver IC 13 and the other ends connected to the third wirings 16c through an anisotropic conductive film (ACF) . The second wirings 16b are wirings which are drawn alternately on both sides of the cathode lines 12e on the lateral sides of the support substrate 11, with their one ends connected to the cathode lines 12e and the other ends connected to the third wirings 16c through the ACF. Each of the second wirings 16b is formed in such a way that at least its end portion that is a connecting portion to the cathode line 12e is positioned below the cathode line 12e through the insulating film 12b so as to be connectable to the cathode line 12e through the contact hole 12b2, as illustrated in Fig. 2.

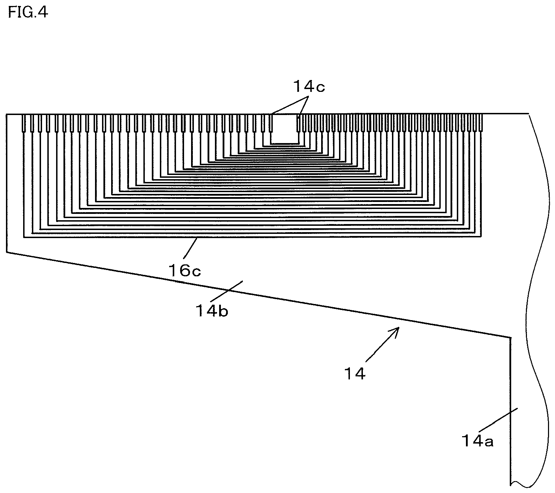

The third wirings 16c are wirings formed on the lateral portions 14b of the substantially T-letter shaped FPC 14, which are made of, for example, a copper foil with a layer thickness of several to dozens µm, in which electric resistance in the same length is smaller than that of the metal wiring of the first and second wirings 16a and 16b. One end of the third wiring 16c is connected to the first wiring 16a through the ACF and the other end is connected to the second wiring 16b through the ACF. As illustrated in Fig. 4, both ends of the third wirings 16c are connected to plural connecting units 14c formed in rows on one side of the FPC 14 (the upper side in Fig. 4) and connected to the first and second wirings 16a and 16b through the connecting units 14c. Intervals (pitch) between the connecting units 14c are not even and the intervals between the connecting units 14c are set wider on the lateral sides than the intervals between the connecting units 14c in a middle portion. Namely, in the embodiment, the connecting units 14 are formed so that the intervals between the connecting units 14c to be connected to the second wirings 16b become wider than the intervals between the connecting units 14c to be connected to the first wirings 16a. In the FPC 14 formed wider, positional deviation caused by thermal deformation (expansion or shrinkage) is larger on the lateral sides than in the middle portion. Therefore, by widening the intervals between the connecting units 14c on the lateral sides, it is possible to restrain a contact malfunction of the connecting units 14c caused by the positional deviation.

The input wiring 17 is a wiring for electrically connecting the driver IC 13 to the external circuit and formed of a conductive material of, for example, ITO that is the same material as that of the anode line 12a, chrome (Cr), aluminum (Al), or the like, or a stack of these conductive materials. The input wiring 17 is drawn and formed near the driver IC 13 on the support substrate 11, with one end connected to the driver IC 13 and the other end connected to the connecting wiring 18 formed on the FPC 14 through the ACF.

The connecting wiring 18 is a wiring formed on the central portion 14a of the FPC 14 and formed of a copper foil, for example, with a layer thickness of several to dozens µm. The connecting wiring 18 has a terminal 18a with one end connected to the input wiring 17 through the ACF and the other end connected to the external circuit.

The organic EL module is formed by the above mentioned units.

In the organic EL module, of the wirings extended from the driver IC 13, the cathode wirings 16 in which large currents flow are separated into the first wiring 16a and the second wiring 16b on the support substrate 11, which are connected to each other through the third wiring 16c formed on the FPC 14. The third wiring 16c formed on the FPC 14 is formed of a copper foil with a thickness of several to dozens µm, much thicker compared with the wiring having the layer thickness of several nm formed on the support substrate 11, and the electric resistance is lower. Therefore, compared with the conventional case of extending all the cathode wirings 6 on the support substrate 1, it is possible to reduce wiring resistance in the cathode wirings 16, restrain a voltage drop, and improve the brightness of the light-emitting pixels. In this embodiment, although the cathode wirings 16 are constituted in that the first and second wirings 16a and 16b decoupled on the support substrate 11 are connected to each other through the third wirings 16c formed on the FPC 14, the invention is not restricted to this application but it may be applied to the anode wirings 15 depending on the design of drawing wirings. When the invention is applied to the anode wirings 15, a first wiring with one end connected to the driver IC 13 and a second wiring with one end connected to the anode line 12a are decoupled on the support substrate 11 and connected to each other through a third wiring formed on the FPC 14. In an example not forming part of the claimed invention, the input wiring being a first wiring with one end connected to the driver IC and a second wiring with one end connected to the external circuit are decoupled on the support substrate 11 and connected to each other through a third wiring formed on the FPC 14.

Further, by making the intervals between the connecting units 14c to connect the third wiring 16c to the first and second wirings 16a and 16b, which are formed on the FPC 14, wider on the lateral sides than the intervals in the middle portion, it is possible to restrain a contact failure caused by the positional deviation in the connecting units 14c as mentioned above.

### INDUSTRIAL APPLICABILITY

The invention is suitable for a COG typed organic EL module.

### DESCRIPTION OF REFERENCE NUMERALS AND SIGNS

- 11: support substrate
- 12: light-emitting display
- 12a: anode line (first electrode line)
- 12b: insulating film
- 12c: partition wall
- 12d: organic layer
- 12e: cathode line (second electrode line)
- 12f: sealing material
- 13: driver IC
- 14: FPC
- 15: anode wiring
- 16: cathode wiring
- 16a: first wiring
- 16b: second wiring
- 16c: third wiring
- 17: input wiring
- 18: connecting wiring

## Claims

1. An organic EL module comprising:
a light-emitting display (12) including a plurality of first electrode lines (12a) formed on a support substrate (11),
an organic light-emitting layer formed on the first electrode lines (12a), and a plurality of second electrode lines (12e) formed so as to intersect with the first electrode lines (12a),
a driver IC (13) which is provided on the support substrate (11) for applying a drive current between the first and the second electrode lines (12a, 12e), and
a circuit board (14) which is installed on the support substrate (11) for connecting the driver IC (13) to an external circuit, wherein
a first wiring (16a) with one end connected to the driver IC (13) and a second wiring (16b) decoupled from the first wiring (16a) are formed on the support substrate (11), and
the first wiring (16a) is connected to the second wiring (16b) through a third wiring (16c) formed on the circuit board (14); **characterized in that**
the second wiring (16b) is formed with one end connected to the first electrode lines (12a) or the second electrode lines (12e) and with the other end connected to the third wiring (16c).

2. The organic EL module according to Claim 1, wherein on the circuit board (14), a plurality of connecting units (14c) for connecting the third wiring (16c) to the first and the second wirings (16b) are formed in rows on one side, and intervals between the connecting units (14c) are wider on lateral sides than intervals between the connecting units (14c) in a middle portion.

3. The organic EL module according to Claim 1, wherein the circuit board (14) is a flexible substrate.

## Patentansprüche

1. Organische-EL-Modul, umfassend:
lichtemittierende Anzeigevorrichtung (12), aufweisend mehrere erste Elektrodenleitungen (12a), ausgebildet auf einem Trägersubstrat (11),
eine organische lichtemittierende Schicht, ausgebildet auf den ersten Elektrodenleitungen (12a) und mehrere zweite Elektrodenleitungen (12e), derart ausgebildet, dass sie die ersten Elektrodenleitungen (12a) schneiden,
einen Treiber-IC (13), welcher auf dem Trägersubstrat (11) vorgesehen ist, zum Einprägen eines Treiberstroms zwischen den ersten und den zweiten Elektrodenleitungen (12a, 12e), und
eine Leiterplatte (14), welche auf dem Trägersubstrat (11) installiert ist, zum Verbinden des Treiber-IC (13) mit einer externen Schaltung, wobei
eine erste Verdrahtung (16a) mit einem Ende mit dem Treiber-IC (13) verbunden und eine von der ersten Verdrahtung (16a) entkoppelte zweite Verdrahtung (16b) auf dem Trägersubstrat (11) ausgebildet sind, und
die erste Verdrahtung (16a) mit der zweiten Verdrahtung (16b) über eine dritte Verdrahtung (16c), ausgebildet auf der Leiterplatte (14), verbunden ist; **dadurch gekennzeichnet, dass**
die zweite Verdrahtung (16b) mit einem Ende mit den ersten Elektrodenleitungen (12a) oder den zweiten Elektrodenleitungen (12e) verbunden und mit dem anderen Ende mit der dritten Verdrahtung (16c) verbunden ausgebildet ist.

2. Organische-EL-Modul nach Anspruch 1, wobei auf der Leiterplatte (14) mehrere Verbindungseinheiten (14c) zum Verbinden der dritten Verdrahtung (16c) mit der ersten und der zweiten Verdrahtung (16b) auf einer Seite in Zeilen ausgebildet sind, und Intervalle zwischen den Verbindungseinheiten (14c) auf Lateralseiten breiter sind als Intervalle zwischen den Verbindungseinheiten (14c) in einem Mittelabschnitt.

3. Organische-EL-Modul nach Anspruch 1, wobei die Leiterplatte (14) ein flexibles Substrat ist.

## Revendications

1. Module électroluminescent organique comprenant :
un afficheur électroluminescent (12) comprenant une pluralité de premières lignes d'électrodes (12a) formées sur un substrat de support (11),
une couche organique électroluminescente formée sur les premières lignes d'électrodes (12a), et une pluralité de deuxièmes lignes d'électrodes (12e) formées de manière à se croiser avec les premières lignes d'électrodes (12a),
un circuit intégré de commande (13) qui est prévu sur le substrat de support (11) pour appliquer un courant d'attaque entre les première et deuxième lignes d'électrodes (12a, 12e), et
une carte de circuit imprimé (14) qui est installée sur le substrat de support (11) pour connecter le circuit intégré de commande (13) à un circuit externe,
un premier câblage (16a) avec une extrémité connectée au circuit intégré de commande (13) et un deuxième câblage (16b) découplé du premier câblage (16a) étant formés sur le substrat de support (11), et
le premier câblage (16a) étant connecté au deuxième câblage (16b) par l'intermédiaire d'un troisième câblage (16c) formé sur la carte de circuit imprimé (14) ; **caractérisé en ce que**
le deuxième câblage (16b) est formé avec une extrémité connectée aux premières lignes d'électrodes (12a) ou aux deuxièmes lignes d'électrodes (12e) et avec l'autre extrémité connectée au troisième câblage (16c).

2. Module électroluminescent organique selon la revendication 1, sur la carte de circuit imprimé (14), une pluralité d'unités de connexion (14c) pour connecter le troisième câblage (16c) aux premier et deuxième câblages (16b) étant formées en rangées sur un côté, et les intervalles entre les unités de connexion (14c) étant plus larges sur les côtés latéraux que les intervalles entre les unités de connexion (14c) dans une partie intermédiaire.

3. Module électroluminescent organique selon la revendication 1, la carte de circuit imprimé (14) étant un substrat flexible.
